# EUROPÄISCHE PATENTANMELDUNG

(11) **EP 2 518 765 A2**
(43) Veröffentlichungstag der Anmeldung: **31.10.2012**
(21) Anmeldenummer: 12159020.2
(22) Anmeldetag: 12.03.2012
(51) Int. Cl.: H01L 25/07, H01L 23/48, H01R 13/24

(54) **Schaltungsanordnung mit Kontaktfedern**

(30) Priorität: 26.04.2011 DE 102011017500
(71) Anmelder: SEMIKRON Elektronik GmbH & Co. KG, 90431 Nürnberg (DE)
(72) Erfinder: Popescu, Alexander, 90431 Nürnberg (DE); Popp, Rainer, 91580 Petersaurach (DE)

(57) **Zusammenfassung**

Es wird eine Schaltungsanordnung (10) beschrieben, mit einem schaltstrukturierten Substrat (36), an dem mindestens ein Halbleiterbauelement (44) vorgesehen ist, und mit Kontaktfedern (16), die in zugehörigen Federschächten (14) eines Gehäusekörpers (12) unverlierbar angeordnet sind, wobei die jeweilige Kontaktfeder (16) als Federstreifen ausgebildet ist, der an seinen beiden voneinander entfernten Endabschnitten (18) jeweils mit einer Kontaktkröpfung (20) ausgebildet ist. An jede Kontaktkröpfung (20) schließt sich distal materialeinstückig eine Endlasche (22) an, von der mindestens einseitig ein Führungsansatz (32) seitlich wegsteht. Der jeweilige Federschacht (14) des Gehäusekörpers (12) ist mit Führungsnuten (24) für die Führungsansätze (32) ausgebildet.

## Beschreibung

Die Erfindung betrifft eine Schaltungsanordnung mit einem schaltstrukturierten Substrat, an dem mindestens ein Halbleiterbauelement vorgesehen ist, und mit Kontaktfedern, die in zugehörigen Federschächten eines Gehäusekörpers unverlierbar angeordnet sind, wobei die jeweilige Kontaktfeder als Federstreifen ausgebildet ist, der an seinen beiden voneinander entfernten Endabschnitten jeweils mit einer Kontaktkröpfung ausgebildet ist.

Eine derartige Schaltungsanordnung ist aus der DE 10 2007 006 212 A1 bekannt. Der jeweilige gestanzte Federstreifen wird gebogen zur entsprechenden Kontaktfeder geformt. Die Federfunktion der jeweiligen Kontaktfeder ist durch die einseitige, doppel-Z-förmige Gestalt des Federstreifens gegeben, d.h. die beiden Z-förmigen Abschnitte sind auf der gleichen Seite des Profils der Kontaktfeder vorgesehen. Das Profil der Kontaktfeder ist also einseitig, unsymmetrisch. Infolge dieses unsymmetrischen, einseitigen Profils werden die Kontaktkröpfungen der jeweiligen Kontaktfeder bei einer Einbau-Belastung, d.h. bei der Kombination des mit den Kontaktfedern bestückten Gehäusekörpers mit dem an der einen Seite des Gehäusekörpers vorgesehenen schaltstrukturierten Substrat und einer an der anderen Seite des Gehäusekörpers angeordneten Schaltungskomponente nicht nur in Richtung des Federschachtes, d.h. in Federrichtung bewegt, sondern außerdem auch in einer dazu orthogonalen Richtung, die in der vom gebogenen Federstreifen aufgespannten Ebene liegt, seitlich verschoben. Durch diese seitliche Verschiebung sind eine entsprechende Reibung der jeweiligen Kontaktkröpfung und ein daraus resultierender, unerwünschter Abrieb nicht zuverlässig vermeidbar, der im Extremfall zu einem Ausfall der Schaltungsanordnung führen kann.

Deshalb liegt der Erfindung die Aufgabe zugrunde, eine Schaltungsanordnung der eingangs genannten Art derartig weiter zu verbessern, dass eine seitliche Verschiebung der Kontaktkröpfungen der jeweiligen Kontaktfeder bei einer Einbaubelastung, wie sie oben beschrieben worden ist, auf konstruktiv einfache Weise vermieden wird.

Diese Aufgabe wird erfindungsgemäß durch die Merkmale des Anspruches 1, d.h. dadurch gelöst, dass sich an jede Kontaktkröpfung distal materialeinstückig eine Endlasche anschließt, von der mindestens einseitig ein Führungsansatz seitlich wegsteht, und dass der jeweilige Federschacht des Gehäusekörpers mit Führungsnuten für die Führungsansätze ausgebildet ist.

Die Führungsnuten erstrecken sich vorzugsweise in einer zum schaltstrukturierten Substrat senkrechten Richtung, so dass die an die Kontaktkröpfungen distal anschließenden Endlaschen sich bei einer Einbaubelastung nur in dieser senkrechten Richtung bewegen können, was bedeutet, dass die an die Endlaschen proximal anschließenden Kontaktkröpfungen sich bei einer Einbaubelastung nur in dieser Richtung und nicht in seitlicher Richtung verschieben können. Ein unerwünschter Abrieb an den Kontaktkröpfungen bzw. am schaltstrukturierten Substrat und/oder an der davon abgewandten Schaltungskomponente, d.h. an den Kontaktpartnern, wird also auf einfache Weise zuverlässig verhindert.

Um einen Linienkontakt durch die jeweilige Kontaktkröpfung zu vermeiden, kann es zweckmäßig sein, wenn die jeweilige Kontaktkröpfung mit einer sich entlang der Kontaktkröpfung erstreckenden Kröpfungsrippe ausgebildet ist. Hierdurch kann der Kontakt zwischen der jeweiligen Kontaktkröpfung und der Kontaktfläche des zugehörigen Kontaktpartners, d.h. des schaltstrukturierten Substrates bzw. der davon durch den Gehäusekörper beabstandeten Schaltungskomponente verringert werden, so dass eine Beschädigung der Kontaktflächen der Kontaktpartner im Betrieb der Schaltungsanordnung, bei welchem Vibrationen o.dgl. oftmals nicht vermeidbar sind, zumindest reduziert oder vermieden wird. Die Betriebszuverlässigkeit der Schaltungsanordnung ist also weiter verbessert.

Als besonders vorteilhaft hat es sich erwiesen, wenn bei der erfindungsgemäßen Schaltungsanordnung die beiden Endlaschen des jeweiligen Federelementes zueinander parallel orientiert und gegeneinander seitlich versetzt sind. Entsprechend sind auch die im jeweiligen Federschacht des Gehäusekörpers vorgesehenen Führungsnuten zueinander parallel orientiert und gegeneinander seitlich versetzt ausgebildet.

Besonders vorteilhaft ist es, wenn von den beiden einander gegenüberliegenden Seiten jeder der beiden Endlaschen jeweils ein Führungsansatz seitlich wegsteht. Bei einer solchen Ausbildung ist der zugehörige, länglich rechteckige Federschacht des Gehäusekörpers an seinen beiden einander gegenüberliegenden Hauptflächen, die zu der von der Kontaktfeder aufgespannten Ebene parallel orientiert sind, jeweils mit einem Paar zueinander parallel orientierten und gegeneinander seitlich versetzten Führungsnuten für die Führungsansätze ausgebildet.

Als zweckmäßig hat es sich erwiesen, wenn die im jeweiligen Federschacht ausgebildeten Führungsnuten zu der von schaltstrukturierten Substrat abgewandten Seite, bei der es sich bspw. um die Oberseite des Gehäusekörpers handelt, hin offen sind, so dass es möglich ist, die Kontaktfedern von der Oberseite des Gehäusekörpers her in den jeweils zugehörigen Federschacht einzusetzen. Damit die jeweilige Kontaktfeder nach diesem Einsetzen von oben nicht aus der dem schaltstrukturierten Substrat zugewandten anderen Seite, d.h. aus der Unterseite des Gehäusekörpers herausfallen kann, ist es bevorzugt, wenn die im jeweiligen Federschacht ausgebildeten Führungsnuten von der Unterseite des Gehäusekörpers beabstandet enden. Auf diese Weise bilden die unterseitigen Enden der Führungsnuten Endanschläge für die seitlichen Führungsansätze der Endlaschen der jeweiligen Kontaktfeder, durch die ein Herausfallen der Kontaktfedern aus den Federschächten nach unten verhindert wird.

Um die Kontaktfedern nicht nur nach unten sondern auch zur Oberseite des Gehäusekörpers hin unverlierbar vorzusehen, ist es bevorzugt, wenn der jeweilige Federschacht in der Nachbarschaft der Oberseite des Gehäusekörpers an einer ersten Schmalseite mit einem in den Federschacht hineinragenden ersten Widerlageransatz ausgebildet ist. Mit Hilfe dieses ersten Widerlageransatzes wird das Federelement daran gehindert, sich ungewollt aus dem Federschacht nach oben heraus zu bewegen, wenn der mit den Kontaktfedern bestückte Gehäusekörper z.B. mit seiner Oberseite nach unten gedreht wird.

Desgleichen ist es möglich, die Führungsnuten im jeweiligen Federschacht des Gehäusekörpers von dessen Oberseite bis zu seiner Unterseite hin durchgehend offen auszubilden und ein Herausfallen der Kontaktfeder aus dem zugehörigen Federschacht nach unten dadurch zu verhindern, dass der Federschacht in der Nachbarschaft der Unterseite an der der ersten Schachtschmalseite gegenüberliegenden zweiten Schachtschmalseite mit einem in den Federschacht hineinragenden zweiten Widerlageransatz ausgebildet ist.

Weitere Einzelheiten, Merkmale und Vorteile ergeben sich aus der nachfolgenden Beschreibung einer in der Zeichnung dargestellten Ausführungsform der erfindungsgemäßen Schaltungsanordnung.

Es zeigen:
Figur 1 eine perspektivische Ansicht einer Ausbildung der Schaltungsanordnung,
Figur 2 das Detail II in Figur 1 in einem größeren Maßstab,
Figur 3 perspektivisch aufgeschnitten eine andere Ansicht der Schaltungsanordnung,
Figur 4 eine teilweise aufgeschnittene Seitenansicht der Schaltungsanordnung,
Figur 5 eine Ausführungsform einer Kontaktfeder der Schaltungsanordnung in einer perspektivischen Ansicht,
Figur 6 eine Ansicht der Kontaktfeder in Blickrichtung des Pfeiles VI in Figur 5, und
Figur 7 eine Ansicht der Kontaktfeder in Blickrichtung des Pfeiles VII in Figur 6.

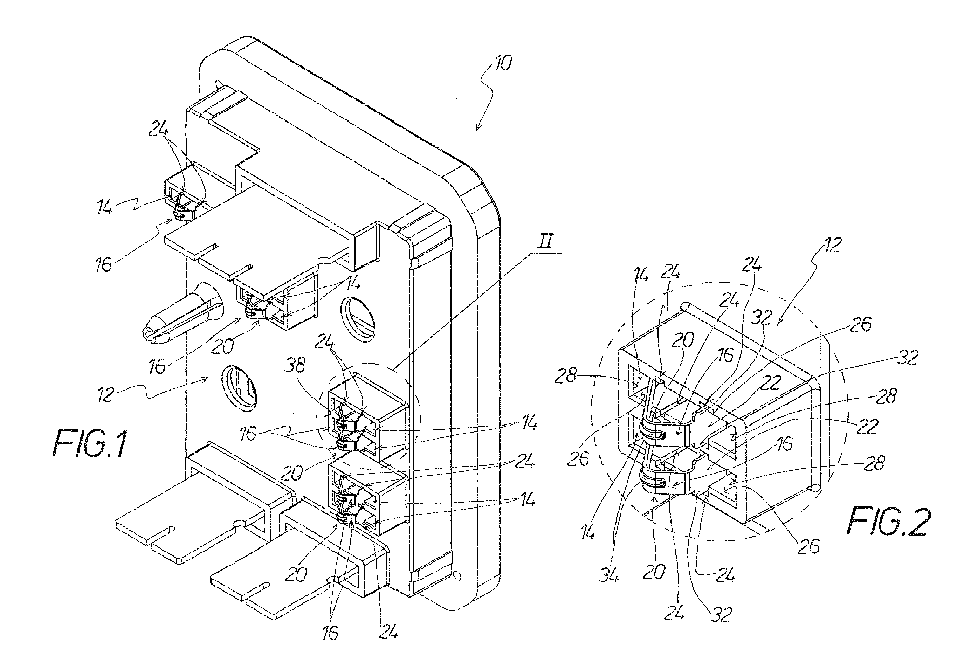

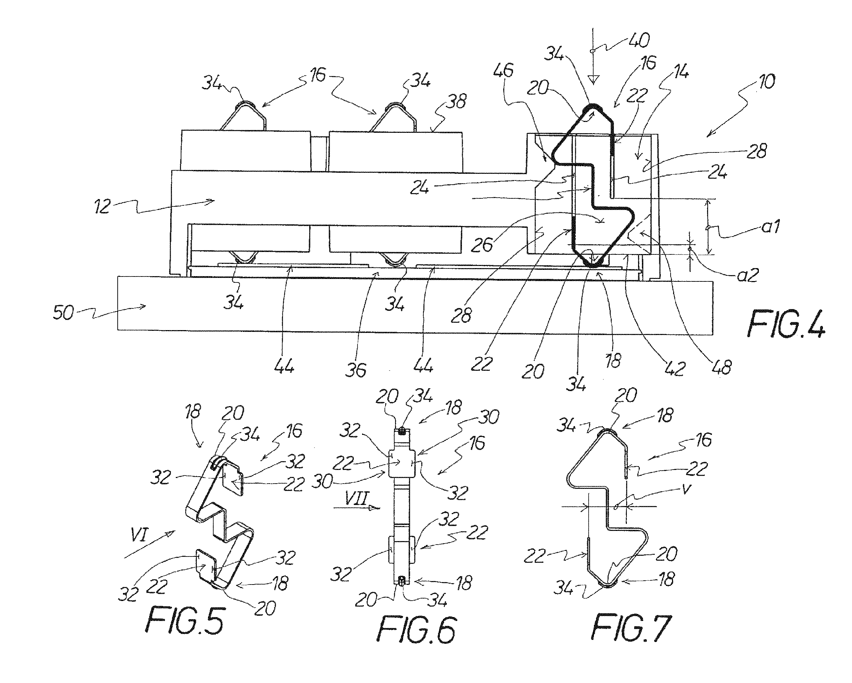

Figur 1 zeigt eine Ausbildung der Schaltungsanordnung 10 mit einem Gehäusekörper 12, der mit Federschächten 14 für Kontaktfedern 16 ausgebildet ist. Eine Ausführungsform einer Kontaktfeder 16 ist in den Figuren 5, 6 und 7 dargestellt, wobei es sich versteht, dass die Kontaktfedern 16 auch anders geformt sein können.

Die jeweilige Kontaktfeder 16 ist von einem gestanzten Federstreifen durch Biegen geformt. An ihren beiden voneinander entfernten Endabschnitten 18 ist jede Kontaktfeder 16 jeweils mit einer Kontaktkröpfung 20 ausgebildet. An die jeweilige Kontaktkröpfung 20 schließt sich distal materialeinstückig eine Endlasche 22 an. Die beiden Endlaschen 22 sind zueinander parallel orientiert und gegeneinander seitlich versetzt. Der seitliche Versatz ist in Figur 7 durch den Doppelpfeil "v" verdeutlicht.

Wie aus den Figuren 2 und 4 deutlich ersichtlich ist, ist der jeweilige Federschacht 14 des Gehäusekörpers 12, bei dem es sich bspw. um ein Gehäuse oder Teilgehäuse eines Leistungshalbleitermoduls oder um eine interne Halte- und Führungseinrichtung innerhalb eines leistungselektronischen Systems handelt, mit Führungsnuten 24 ausgebildet. Die Führungsnuten 24 sind in den einander gegenüberliegenden Hauptflächen 26 des jeweiligen Federschachtes 14 ausgebildet. Die die Hauptflächen 26 miteinander verbindenden Schachtschmalflächen des jeweiligen Federschachtes 14 sind mit der Bezugsziffer 28 bezeichnet.

Die Endlaschen 22 jedes Federelementes 16 sind an ihren beiden einander gegenüberliegenden Seiten 30 (siehe insbesondere Figur 6) jeweils mit einem Führungsansatz 32 ausgebildet. Die Führungsansätze 32 stehen in die zugehörigen Führungsnuten 24 des zugehörigen Führungsschachtes 14 längsbeweglich geführt hinein, so dass die Kontaktkröpfungen 20 der Kontaktfedern 16 sich bei einer Einbaubelastung nur in der durch die Führungsnuten 24 bestimmten Raumrichtung bewegen. Eine unerwünschte Bewegung in der hierzu orthogonalen, seitlichen Richtung wird erhindert, so dass auch ein daraus resultierender Abrieb, der im Extremfall zu einem Ausfall der Schaltungsanordnung 10 führen könnte, zuverlässig verhindert wird.

Die beiden Kontaktkröpfungen 20 der jeweiligen Kontaktfeder 16 sind mit einer Kröpfungsrippe 34 ausgebildet, die sich entlang der entsprechenden Kontaktkröpfung 20 erstreckt. Die Kröpfungsrippe 34 ist in Breitenrichtung der jeweiligen Kontaktfeder 16 gesehen, vorzugsweise in einem mittleren Bereich derselben ausgebildet.

Wie insbesondere aus Figur 4 ersichtlich ist, sind die im jeweiligen Federschacht 14 ausgebildeten Führungsnuten 24 zu der von einem Substrat 36 der Schaltungsanordnung 10 abgewandten Oberseite 38 des Gehäusekörpers 12 hin offen, so dass es problemlos möglich ist, die jeweilige Kontaktfeder 16 von oben her in den zugehörigen Federschacht 14 einzusetzen. Das ist in Figur 4 durch den Pfeil 40 angedeutet. Damit die jeweilige Kontaktfeder 16 aus dem zugehörigen Federschacht 14 nicht nach unten, d.h. aus der Unterseite 42 des Gehäusekörpers 12, herausfallen kann, enden die Führungsnuten 24 jeweils in einem definierten Abstand von der Unterseite 42. Diese Abstände sind in Figur 4 mit "a1" und "a2" bezeichnet.

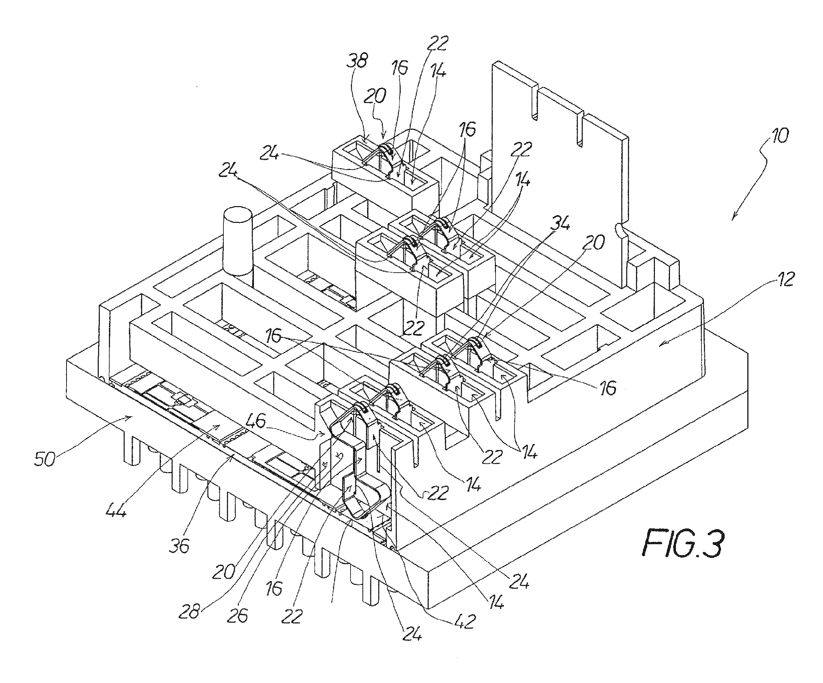

In den Figuren 1 bis 4 sind die Kontaktfedern 16 am Substrat 36 bzw. an Halbleiterbauelementen 44 des Substrates 36 anliegend gezeichnet, aber noch nicht mit einer weiteren (nicht gezeichneten) Schaltungskomponente kombiniert, die an der Oberseite 38 des Gehäusekörpers 12 angeordnet wird, so dass die jeweilige Kontaktfeder 16 noch auf einem ersten Widerlageransatz 46 (siehe Figur 4) aufliegt. Im mit einer Schaltungskomponente kombinierten Zustand der Schaltungsanordnung 10 befindet sich dann der von der zugehörigen Schachtschmalseite 28 in den Federschacht 14 hineinragende erste Widerlageransatz 36 nicht unter sondern über der entsprechenden Biegung der Kontaktfeder 16, so dass die Kontaktfeder 16 an einem ungewollten Herausfallen aus dem Federschacht 14 nach oben, d.h. aus der Oberseite 38 des Gehäusekörpers 12 heraus, gehindert wird.

Ein zweiter Widerlageransatz 48 kann in der Nachbarschaft der Unterseite 42 des Gehäusekörpers 12 an der der ersten Schachtschmalseite 28 gegenüberliegenden zweiten Schachtschmalseite 28 ausgebildet sein. Dieser zweite Widerlageransatz ist in Figur 4 strichliert angedeutet.

Mit der Bezugsziffer 50 ist ein Kühlkörper bezeichnet, der in bekannter Weise dazu vorgesehen ist, Wärme vom Substrat 36 der Schaltungsanordnung 10 abzuführen.

Gleiche Einzelheiten sind in allen Figuren jeweils mit denselben Bezugsziffern bezeichnet, so dass es sich erübrigt, in Verbindung mit allen Figuren alle Einzelheiten jeweils detailliert zu beschreiben.

### Bezugsziffernliste:

- 10: Schaltungsanordnung
- 12: Gehäusekörper (von 10)
- 14: Federschacht (in 12 für 16)
- 16: Kontaktfeder (in 14 zwischen 36 bzw. 44)
- 18: Endabschnitt (von 16)
- 20: Kontaktkröpfung (an 18)
- 22: Endlasche (bei 20)
- 24: Führungsnut (in 14 bzw. 26)
- 26: Schachthauptfläche (von 14)
- 28: Schachtschmalfläche (von 14)
- 30: Seite (von 22)
- 32: Führungsansatz (an 30)
- 34: Kröpfungsrippe (an 20)
- 36: Substrat (von 10)
- 38: Oberseite (von 12)
- 40: Pfeil/ Einsetzbewegung (von 16 in 14)
- 42: Unterseite (von 12)
- 44: Halbleiterbauelement (an 36)
- 46: erster Widerlageransatz (an 28 für 16)
- 48: zweiter Widerlageransatz (an 28 für 16)
- 50: Kühlkörper (von 10)

## Patentansprüche

1. Schaltungsanordnung mit einem schaltstrukturierten Substrat (36), an dem mindestens ein Halbleiterbauelement (44) vorgesehen ist, und mit Kontaktfedern (16), die in zugehörigen Federschächten (14) eines Gehäusekörpers (12) unverlierbar angeordnet sind, wobei die jeweilige Kontaktfeder (16) als Federstreifen ausgebildet ist, der an seinen beiden voneinander entfernten Endabschnitten (18) jeweils mit einer Kontaktkröpfung (20) ausgebildet ist,
**dadurch gekennzeichnet,**
**dass** sich an jede Kontaktkröpfung (20) distal materialeinstückig eine Endlasche (22) anschließt, von der mindestens einseitig ein Führungsansatz (32) seitlich wegsteht, und dass der jeweilige Federschacht (14) des Gehäusekörpers (12) mit Führungsnuten (24) für die Führungsansätze (32) ausgebildet ist.

2. Schaltungsanordnung nach Anspruch 1,
**dadurch gekennzeichnet,**
**dass** die jeweilige Kontaktkröpfung (20) mit einer sich entlang der Kontaktkröpfung erstreckenden Kröpfungsrippe (34) ausgebildet ist.

3. Schaltungsanordnung nach Anspruch 1,
**dadurch gekennzeichnet,**
**dass** die beiden Endlaschen (22) der jeweiligen Kontaktfeder (16) zueinander parallel orientiert und gegeneinander seitlich versetzt sind.

4. Schaltungsanordnung nach einem der Ansprüche 1 bis 3,
**dadurch gekennzeichnet,**
**dass** von den beiden einander gegenüberliegenden Seitenrändern (30) jeder der beiden Endlaschen (22) der jeweiligen Kontaktfeder (16) jeweils ein Führungsansatz (32) seitlich wegsteht.

5. Schaltungsanordnung nach Anspruch 1,
**dadurch gekennzeichnet,**
**dass** die im jeweiligen Federschacht (14) ausgebildeten Führungsnuten (24) zu der von schaltstrukturierten Substrat (36) abgewandten Oberseite (38) des Gehäusekörpers (12) hin offen sind.

6. Schaltungsanordnung nach Anspruch 1,
**dadurch gekennzeichnet,**
**dass** die im jeweiligen Federschacht (14) ausgebildeten Führungsnuten (24) von der Unterseite (42) des Gehäusekörpers (12) beabstandet enden.

7. Schaltungsanordnung nach Anspruch 1,
**dadurch gekennzeichnet,**
**dass** der jeweilige Federschacht (14) in der Nachbarschaft der Oberseite (38) des Gehäusekörpers (12) an einer ersten Schachtschmalseite (28) mit einem in den Federschacht (14) hineinragenden ersten Widerlageransatz (46) für die zugehörige Kontaktfeder (16) ausgebildet ist.

8. Schaltungsanordnung nach Anspruch 7,
**dadurch gekennzeichnet,**
**dass** der jeweilige Federschacht (14) in der Nachbarschaft der Unterseite (42) des Gehäusekörpers (12) an der der ersten Schachtschmalseite (28) gegenüberliegenden zweiten Schachtschmalseite (28) mit einem in den Federschacht (14) hineinragenden zweiten Widerlageransatz (46) für die zugehörige Kontaktfeder (16) ausgebildet ist.
